# EUROPÄISCHE PATENTSCHRIFT

(11) **EP 2 456 017 B1**
(45) Veröffentlichungstag und Bekanntmachung des Hinweises auf die Patenterteilung: **04.06.2014**
(21) Anmeldenummer: 10191655.9
(22) Anmeldetag: 18.11.2010
(51) Int. Cl.: H01R 13/516, H01R 13/64, H01R 35/04, H02G 3/16, H04Q 1/14, H05K 7/14, H01R 9/26

(54) **Steckervorrichtung für elektronische Baugruppen in Automatisierungssystemen**
Connector device for electronic components in automation systems
Dispositif de connecteur pour composants électroniques dans des systèmes d'automatisation

(43) Veröffentlichungstag der Anmeldung: 23.05.2012
(73) Patentinhaber: Siemens Aktiengesellschaft, 80333 München (DE)
(72) Erfinder: Donhauser, Peter, 92224, Amberg (DE); Drehmann, Gennadij, 92224, Amberg (DE)

(56) Entgegenhaltungen:
- EP-A1- 1 524 890
- EP-A2- 0 844 691
- EP-A2- 1 267 455
- US-A- 3 992 654
- US-A- 5 104 331
- US-A- 5 777 843

## Beschreibung

Die Erfindung betrifft eine Steckervorrichtung für elektronische Baugruppen mit einem Gehäuse, insbesondere in Automatisierungssystemen, aufweisend ein Anschlussfeld mit Steckplätzen für eine Verdrahtung, und ein Kontaktsystem wobei das Anschlussfeld der elektronischen Baugruppe mittels Schwenktechnik zuführbar ist.

Der Anschluss von elektronischen Baugruppen, insbesondere von Peripheriebaugruppen in Automatisierungssystemen erfolgt üblicherweise mittels Steckervorrichtungen, insbesondere Frontsteckern, welche die entsprechende Prozessleitung über eine quasi stehende Verdrahtung mit der Peripherie kontaktieren. Bei einem Baugruppentausch müssen somit nur die Frontstecker abgenommen und keine Leitungen gelöst werden.

Leiterplatten, Baugruppen oder Steckplatten für elektronische Steuergeräte werden vorteilhafter Weise in genormte Gehäuse eingesetzt. Ein Baugruppenträger nimmt dabei die über Führungsschienen einsteckbaren Baugruppen auf. Die Baugruppen werden über Anschlusskontakte, die entweder auf der Frontseite oder rückwärts/seitlich angebracht sind, mit Spannung bzw. Signalen versorgt. Die Verdrahtung der Baugruppen untereinander kann auch von der Rückseite erfolgen.

Die Gehäuse haben festgelegte Abmessungen, dienen zur Aufnahme von Leiterplatten und werden in genormte Schaltschränke eingebaut. Ein Gehäuse ist aufgebaut aus zwei Seitenteilen mit Befestigungsflanschen, die durch 4 Strangprofile miteinander verbunden sind. Über die beiden Befestigungsflansche wird das Gehäuse in einen Elektronikschrank eingeschraubt.

In das Gehäuse eingeschobene Steckbaugruppen wie z. B. Leiterplatten werden durch äußere Prozess-Signale angesteuert oder sind mit anderen Steckbaugruppen verbunden. Hierfür werden Steckverbinder, insbesondere Frontstecker in Form von Steckerleisten verwendet, die von der Bedienseite her auf die Steckbaugruppe aufgeschoben werden. Bei der Auswahl der Steckverbinder ist neben der Wirtschaftlichkeit und der benötigten Kontaktstifte vor allem zu achten auf Zuverlässigkeit der Steckverbindung, mechanische Robustheit, Kombinierbarkeit von Teilen, die verschiedene Hersteller liefern, Isolationsvermögen und Strombelastung. Die allgemein verwendeten Steckverbinder für direkte Steckung erfüllen alle Wirtschaftlichkeits- und Zuverlässigkeitsanforderungen, nur ist die Anzahl der Kontaktstifte oft nicht ausreichend. Der Prozessfrontstecker kommt vor allem bei Peripheriegeräten zum Einsatz, wenn z. B. zur Vermeidung elektrischer Störbeeinflussung eine räumliche Trennung der Anlagenkabel von den elektronikinternen Signalleitungen zweckmäßig ist.

Die EP 1 524 890 A1 beschreibt eine elektrische Baugruppe und eine Trägerplatte mit einem System zum einfachen Austausch von Elektronikmodulen der dezentralen Peripherie eines Automatisierungssystems. Die elektrische Baugruppe besteht aus einem Elektronikmodul und einem Steckermodul, welche gekoppelt sind. Zum Wechseln der Baugruppe kann das Steckermodul von der Trägerplatte geschwenkt werden. Durch die Schwenkbewegung liegt das Elektronikmodul frei auf dem Steckermodul und kann durch Abziehen gewechselt werden. Das Steckermodul selbst verbleibt an der Trägerplatte.

Der Nachteil am Stand der Technik besteht jedoch darin, dass Steckervorrichtungen für elektronische Baugruppen in Automatisierungssystemen, die mittels Schwenktechnik verbaubar sind, bisher keine Vorverdrahtungsstellung aufweisen. Dies führt dazu, dass sich bei diesen Steckervorrichtungen die Anschlussfelder, d. h. also die Klemmen, beim Verdrahten innerhalb der elektronischen Baugruppe, befinden. Die Leitereinführung ist somit nicht einfach und die Zugänglichkeit der Klemmen schwierig.

Demgemäß besteht die Aufgabe der vorliegenden Erfindung darin, eine Steckervorrichtung für elektronische Baugruppen zu schaffen, die eine leicht zugängliche Vorverdrahtung ermöglicht.

Diese Aufgabe wird durch eine Steckervorrichtung mit den Merkmalen des Patentanspruchs 1 gelöst. Vorteilhafte Aus- und Weiterbildungen, welche einzeln oder in Kombination miteinander eingesetzt werden können, sind der Gegenstand der abhängigen Ansprüche.

Erfindungsgemäß wird diese Aufgabe durch eine Steckervorrichtung für elektronische Baugruppen mit einem Gehäuse, insbesondere in Automatisierungssystemen, gelöst, die ein Anschlussfeld mit Steckplätzen für eine Verdrahtung aufweist, wobei das Anschlussfeld der elektronischen Baugruppe mittels Schwenktechnik zuführbar ist. Die Erfindung zeichnet sich dabei dadurch aus, dass die mittels Schwenktechnik an der Baugruppe verbaubare Steckervorrichtung eine Vorverdrahtungsstellung aufweist.

Erfindungsgemäß ist vorgesehen, dass die Steckervorrichtung, vorzugsweise ein Frontstecker, in der Schwenktechnik auf die elektronische Baugruppe kontaktiert und im oberen Bereich der Steckervorrichtung ein Rastelement vorgesehen ist, das eine Verriegelung ermöglicht. Die erfindungsgemäße Steckervorrichtung ist in der Schwenktechnik konzipiert, wodurch Steck- und Ziehkräfte reduziert werden. Erfindungsgemäß ist weiterhin vorgesehen, dass ein Steckerlager sowohl für die Vorverdrahtung als auch für die Kontaktierung verantwortlich ist. Die erfindungsgemäße Steckervorrichtung verrastet in der Vorverdrahtungsstellung fest mit der elektronischen Baugruppe. Dies wird über ein Rastsystem bewerkstelligt. Mittels Lagerzapfen, die sonst als Zuführungsnocken dienen, wird die Steckervorrichtung in die Vorrastlagerstellung eingehängt und durch Einschwenken mit der elektronischen Baugruppe verrastet. Der an der Steckervorrichtung angebrachte Verriegelungsmechanismus verrastet auch in dieser Position den Stecker mit der Baugruppe. In dieser Steckerposition befinden sich die Anschlussklemmen, d. h. das Verdrahtungsfeld, außerhalb der elektronischen Baugruppe und sind leicht zugänglich. Das Kontaktsystem aus Buchse und Messern ist dabei noch nicht im Eingriff.

In einer besonders vorteilhaften Ausführungsform ist vorgesehen, dass die Steckervorrichtung in der Vorverdrahtungsstellung mit der elektronischen Baugruppe verrastbar ist. Mit Lagerzapfen, die sonst als Zuführungsnocken dienen, wird die Steckervorrichtung in die Vorrastlagerstelle eingehängt und durch Einschwenken mit der Baugruppe verrastet. Der an der Steckervorrichtung angebrachte Verriegelungsmechanismus verrastet auch in dieser Position den Stecker mit der Baugruppe. In dieser Steckerposition befinden sich die Anschlussklemmen, d.h. also das Verdrahtungsfeld, außerhalb der Baugruppe und sind leicht zugänglich. Das Kontaktsystem aus Buchse und Messer ist dabei noch nicht im Eingriff.

Es ist insbesondere vorteilhafterweise vorgesehen, dass die Steckervorrichtung der Baugruppe mit unterschiedlichen Neigungswinkeln zuführbar ist, wobei insbesondere eine Steckerneigung zur Baugruppe von ca. 45° bis 135° vorgesehen ist. Eine technische Voraussetzung besteht dabei darin, dass bei den unterschiedlichen Neigungswinkeln die Steckervorrichtung sicher auf der Kontaktierungslagerstelle zugeführt werden muss und dabei ein Codierelement aufgenommen werden kann.

Der große Vorteil der erfindungsgemäßen Steckervorrichtung besteht insbesondere darin, dass hier ein sehr breiter Neigungswinkelbereich gewählt werden kann. In diesem gewählten Neigungswinkelbereich findet die erfindungsgemäße Steckervorrichtung immer die gewählte Codierung. Das Codierelement ist im Bereich des Steckerlagers angeordnet und ist im Auslieferzustand auf der elektronischen Baugruppe positioniert. Nach dem ersten Ein- und Ausschwenken der Steckervorrichtung wird ein Teil des Codierelements von der Steckervorrichtung abgenommen, so dass die Steckervorrichtung nur noch auf denselben Baugruppentyp passt.

In einer weiteren vorteilhaften Ausführungsform ist vorgesehen, dass die Steckplätze in der Vorverdrahtungsstellung au-βerhalb der Baugruppe angeordnet sind. Dazu ist vorgesehen, dass die erfindungsgemäße Steckervorrichtung in der Vorverdrahtungsstellung fest mit der elektronischen Baugruppe verrastet ist. Mittels Lagerzapfen, die sonst als Zuführungsnocken dienen, wird die Steckervorrichtung in der Vorrastlagerstelle eingehängt und durch Einschwenken mit der Baugruppe verrastet. Der an der Steckervorrichtung angebrachte Verriegelungsmechanismus verrastet auch in dieser Position den Stecker mit der elektronischen Baugruppe. In dieser Steckerposition befinden sich die Anschlussklemmen außerhalb der Baugruppe und sind leicht zugänglich. Das Kontaktsystem aus Buchse und Messer ist dabei noch nicht im Eingriff.

Weiterhin ist erfindungsgemäß in vorteilhafter Weise vorgesehen, dass die Steckervorrichtung über einen Verriegelungsmechanismus aus der Vorverdrahtungsstellung entriegelbar ist. Mittels Zuführung in der Fronthaube wird die Steckervorrichtung über Lagerzapfen in der Vorraststellung direkt der Kontaktierungslagerstelle zugeführt. Der Stecker braucht aus der Vorraststellung nicht entnommen zu werden, sondern nur leicht aus der Lagerstellung gehoben und dann durch Einschieben in die Kontaktierungslagerstelle gebracht zu werden. Dies beschreibt den Vorgang der Montage der Steckervorrichtung auf der Baugruppe in die Kontaktierungsposition aus einer vorangegangenen Vorverdrahtungsposition.

Erfindungsgemäß ist es jedoch ebenso möglich, dass die bereits verdrahtete Steckervorrichtung direkt in die Kontaktierungslagerstelle eingehängt wird. Dabei wird die Steckervorrichtung von außen an die Baugruppe herangeführt. Die Lagerzapfen der Vorraststellung führen die Steckervorrichtung direkt in die Kontaktierungslagerstelle. Befindet sich die Steckervorrichtung mit ihrer Lagerschale in der Kontaktierungslagerstelle, wird durch Einschwenken eine elektrische Kontaktierung hergestellt und die Steckervorrichtung mit der Baugruppe mechanisch verriegelt.

Es ist insbesondere in vorteilhafter Weise vorgesehen, dass die Steckervorrichtung mittels Kulissenzuführung im Gehäuse der elektronischen Baugruppe über einen Lagerzapfen einer Kontaktierungslagerstelle zuführbar ist. Die Kulissenzuführungen ermöglichen dabei eine definierte Bewegung der Steckervorrichtung auf die Baugruppe zu.

In einer besonders vorteilhaften Ausführungsform ist vorgesehen, dass die Baugruppe im Auslieferzustand ein Codierelement aufweist. Das Codierelement ist im Bereich des Steckerlagers angeordnet und im Auslieferzustand auf der elektronischen Baugruppe positioniert. Nach dem ersten Ein- und Ausschwenken der Steckervorrichtung wird ein Teil des Codierelements von der Steckervorrichtung abgenommen, so dass die Steckervorrichtung nur noch auf diesen Baugruppentyp passt.

In einem weiteren erfindungsgemäßen Ausführungsbeispiel ist vorgesehen, dass die Steckervorrichtung durch Ausschwenken nach unten, so dass die Steckervorrichtung in einem Winkel von ca. 90° zur elektronischen Baugruppe angeordnet ist, von der elektronischen Baugruppe entnehmbar ist. Diese Ausführungsform stellt eine weitere zusätzliche Entnahmemöglichkeit dar, da technisch auch die Möglichkeit besteht, die Zuführungskulissen für die Entnahme zu verwenden. Die Entnahmemöglichkeit sieht vor, dass durch Zug an der Verriegelungslasche der Verrastungsmechanismus gelöst wird und die Steckervorrichtung von der Baugruppe gezogen bzw. ausgeschwenkt wird. Dies wird durch eine Unterbrechung in den Zuführungsnuten der Baugruppe ermöglicht, so dass die Steckervorrichtung in den ausgeschwenkten Zustand direkt von der Baugruppe entnommen werden kann. Durch diese zusätzliche Entnahmemöglichkeit ist es nicht mehr notwendig, die umgekehrte Reihenfolge der Montage einzuhalten.

Die erfindungsgemäße Steckervorrichtung ermöglicht in ihrer Vorverdrahtungsstellung eine leicht zugängliche Vorverdrahtung außerhalb der elektronischen Baugruppe. Die zusätzliche Verwendung eines Codierelements trägt dazu bei, dass Steckervorrichtungen desselben Baugruppentyps verwendet werden können. Die erfindungsgemäße Steckervorrichtung ermöglicht sowohl einen vorverdrahteten Stecker ohne die Vorverdrahtungsstellung zu durchlaufen, in die Kontaktierungsstellung zu überführen, als auch einen nicht vorverdrahteten Stecker mittels der Vorverdrahtungsstellung in die Kontaktierungsposition zu überführen. Zudem ist die erfindungsgemäße Steckervorrichtung in einem breiten Neigungswinkelbereich von ca. 45° bis 135° anwendbar. Vorteilhaft ist ebenso, dass eine Unterbrechung in den Zuführungsnuten der elektronischen Baugruppe eine direkte Entnahme von der elektronischen Baugruppe ermöglicht, so dass die Montage nicht in umgekehrter Reihenfolge durchlaufen werden muss.

Weitere Vorteile und Ausführungen der Erfindung werden nachfolgend anhand von Ausführungsbeispielen sowie anhand der Zeichnung erläutert.

Dabei zeigen schematisch:
- Fig. 1: in einer perspektivischen Darstellung eine erfindungsgemäße Steckervorrichtung in einer Vorverdrahtungsstellung eingebaut in eine elektronische Baugruppe;
- Fig. 2: in einer Schnittdarstellung eine Steckervorrichtung in der Vorverdrahtungsstellung verriegelt in einer elektronischen Baugruppe;
- Fig. 3: in einer perspektivischen Darstellung die erfindungsgemäße Steckervorrichtung, die sich aus der Vorverdrahtungsstellung in die Kontaktierungsposition bewegt;
- Fig. 4: in einer perspektivischen Darstellung ein Ausschnitt aus Fig. 3, der die in der Gehäusewand der Baugruppe angeordnete Führungskulisse zeigt, auf welcher die Steckervorrichtung aus der Vorverdrahtungsstellung in die Kontaktierungsposition wechselt;
- Fig. 5: in einer perspektivischen Darstellung die Steckervorrichtung, die bei externer Verdrahtung die Kontaktierungsposition wechselt;
- Fig. 6: in einer perspektivischen Darstellung ein Ausschnitt aus Fig. 5, der die in der Gehäusewand der Baugruppe angeordnete Führungskulisse zeigt, auf welcher die Steckervorrichtung bei externer Verdrahtung in die Kontaktierungsposition wechselt;
- Fig. 7: in einer perspektivischen Darstellung eine elektronische Baugruppe mit Codierungselement im Auslieferzustand;
- Fig. 8: in einer perspektivischen Darstellung die erfindungsgemäße Steckervorrichtung beim Ausschwenken aus einer elektronischen Baugruppe;
- Fig. 9: in einer perspektivischen Darstellung die erfindungsgemäße Steckervorrichtung beim Ausschwenken aus einer elektronischen Baugruppe, wobei das Codierelement in zwei Teile getrennt wird;
- Fig. 10: in einer perspektivischen Darstellung die Entnahmemöglichkeit der Steckervorrichtung aus der elektronischen Baugruppe nach dem Ausschwenken.

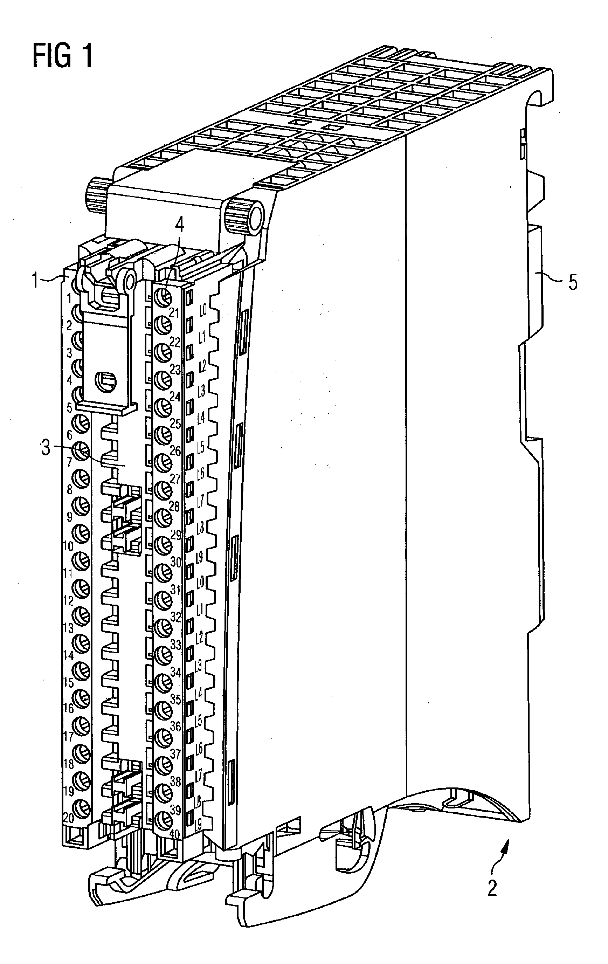

In Fig. 1 ist eine erfindungsgemäße Steckervorrichtung 1 dargestellt, die in eine elektronische Baugruppe 2 eingebaut ist. Die Steckervorrichtung 1 ist vorzugsweise als Frontstecker ausgebildet und weist ein Anschlussfeld 3 auf, in welchem Steckplätze 4 für elektrische Zuleitungen angeordnet sind. Die elektronische Baugruppe 2 weist ein Gehäuse 5 auf, das vorzugsweise quaderförmig ausgebildet ist, wobei ein Seitenteil als Öffnung ausgeformt ist, so dass in diese Öffnung die erfindungsgemäße Steckervorrichtung 1 einschiebbar ist.

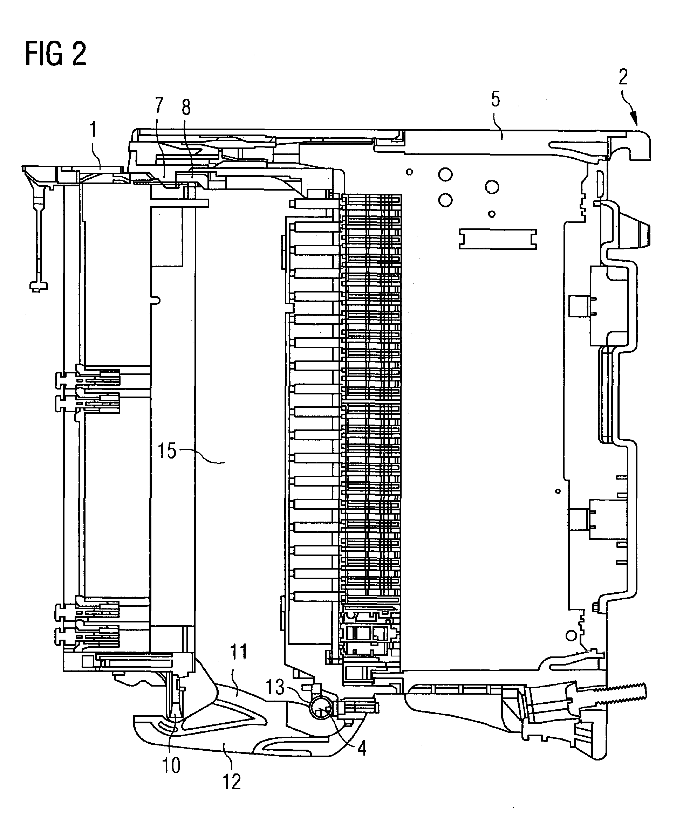

Fig. 2 zeigt die erfindungsgemäße Steckervorrichtung 1 in der Vorverdrahtungsstellung, in welcher sie an der elektronischen Baugruppe 2 verriegelt ist. Die elektronische Baugruppe 2 weist im Gehäusedeckelbereich 6 eine Verriegelungsnase 7 auf, die im Eingriff mit einem Verriegelungshaken 8 an der Steckervorrichtung 1 steht. Zudem weist das Gehäuse 5 der elektronischen Baugruppe 2, das zweiteilig als Fronthaube im Bereich der Steckervorrichtung 1 und daran anschließendes Grundgehäuse ausgebildet sein kann, im Gehäuseunterbodenbereich 9 eine Vorverdrahtungslagerstelle 10 auf, die die Steckervorrichtung 1 auch im unteren Bereich des Gehäuses 5 der elektronischen Baugruppe 2 fixiert, so dass die Steckervorrichtung 1 in dieser Vorverdrahtungsstellung mit elektrischen Zuleitungen bestückt werden kann.

Aus Fig. 2 gehen zudem zwei Führungskulissen 11, 12 hervor, die in der Nähe des Gehäuseunterbodenbereichs 9 angeordnet sind. Die Führungskulisse 11 kann von der Steckervorrichtung 1 durch leichtes Anheben aus der Vorverdrahtungslagerstelle 10 erreicht werden. Die Führungskulisse 11 verläuft in einem leichten Bogen nach unten und bewegt sich dabei auf eine Kontaktierungslagerstelle 13 zu, die seitlich neben einem Codierelement 14 angeordnet ist, das im Auslieferzustand komplett an der elektronischen Baugruppe 2 befestigt ist. Zwischen der Steckervorrichtung 1 und der elektronischen Baugruppe 2 ist ein freier Bereich 15 angeordnet, so dass das Kontaktsystem aus Buchse und Messer in der Vorverdrahtungsstellung noch nicht kontaktiert ist.

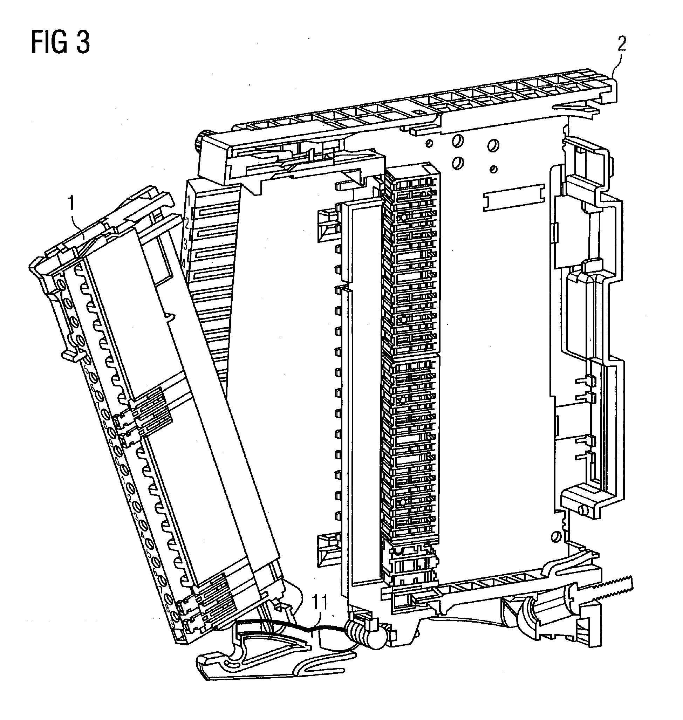

Fig. 3 zeigt die erfindungsgemäße Steckervorrichtung 1, die sich auf der Führungskulisse 11 aus der Vorverdrahtungsstellung in die Kontaktierungsposition bewegt.

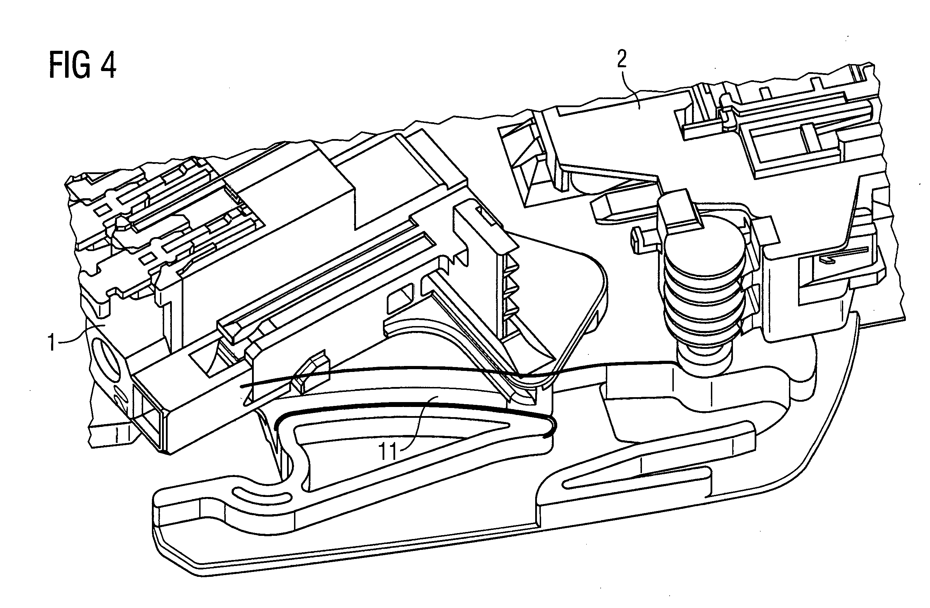

In Fig. 4 ist ein vergrößerter Ausschnitt aus Fig. 3 gezeigt, der die in der Gehäusewand der Baugruppe 2 angeordneten Führungskulisse 11 zeigt, auf welcher die Steckervorrichtung 1 aus der Vorverdrahtungsstellung in die Kontaktierungsposition wechselt. Die Führungskulisse 11 ist dabei im Wesentlichen als vorzugsweise bogenförmiger Führungssteg ausgebildet, auf welchem die Steckervorrichtung 1 geführt ist.

Die erfindungsgemäße Steckervorrichtung 1 kann entweder in der Vorverdrahtungsstellung mit elektrischen Zuleitungen bestückt werden oder extern verdrahtet werden, um dann direkt in die Kontaktierungsposition überführt zu werden. Dabei wird die Steckervorrichtung 1 von außen an die Baugruppe 2 herangeführt. Die Lagerzapfen der Vorraststellung führen die Steckervorrichtung direkt in die Kontaktierungslagerstelle. Befindet sich die Steckervorrichtung 1 mit einer Lagerschale in der Kontaktierungslagerstelle 13, wird durch Einschwenken die elektrische Kontaktierung hergestellt und die Steckervorrichtung 1 mit der Baugruppe 2 mechanisch verriegelt.

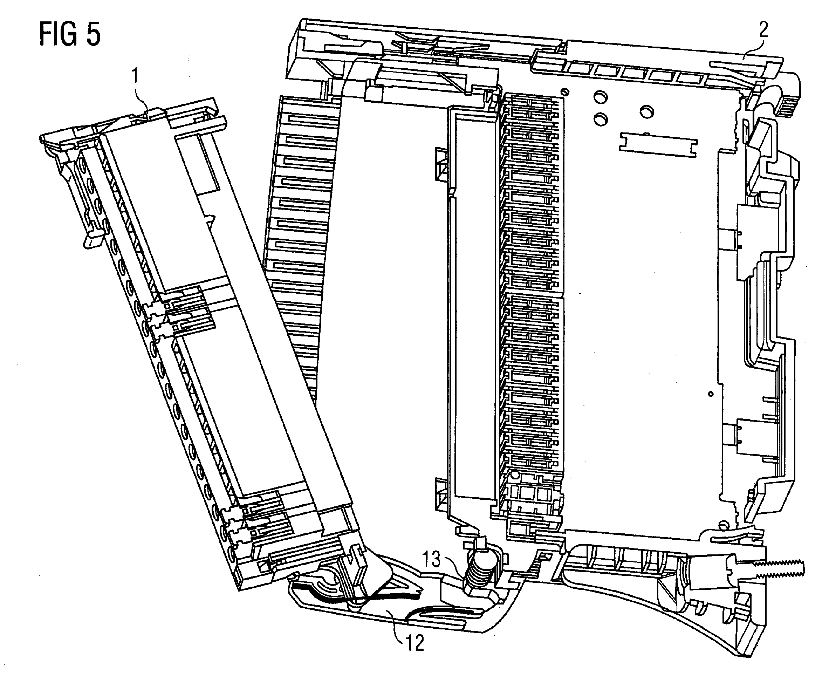

Dazu ist in Fig. 5 die erfindungsgemäße Steckervorrichtung 1 dargestellt, die bei externer Verdrahtung in die Kontaktierungsposition überführt wird. Dazu wird die Führungskulisse 12 genutzt. Die Führungskulisse 12 verläuft von unten leicht bogenförmig in Richtung der Kontaktierungslagerstelle 13.

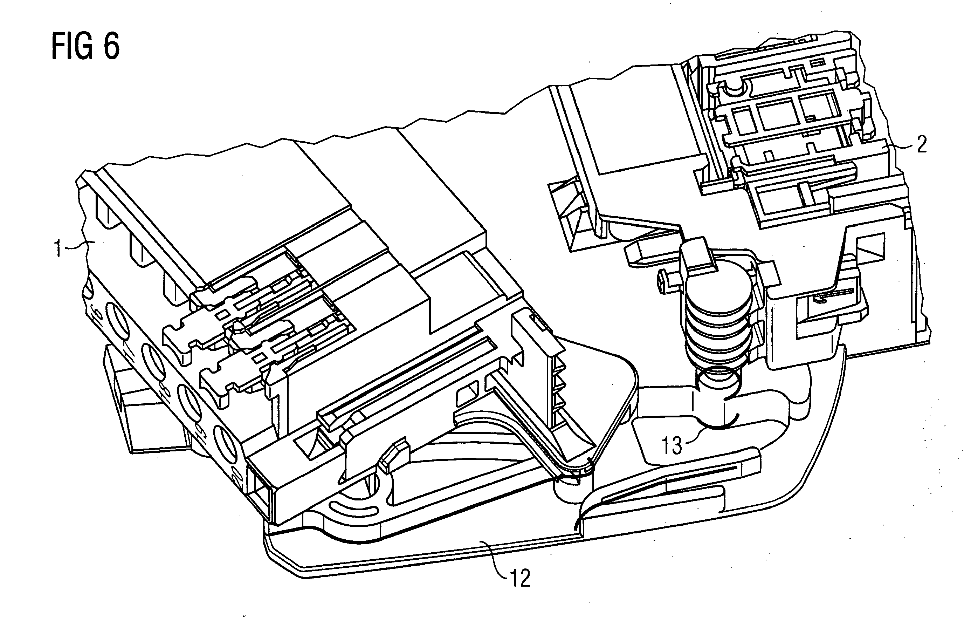

In Fig. 6 ist ein vergrößerter Ausschnitt aus Fig. 5 dargestellt, der die in der Gehäusewand der Baugruppe 2 angeordnete Führungskulisse 12 zeigt, auf welcher die Steckervorrichtung 1 bei externer Verdrahtung in die Kontaktierungsposition wechselt.

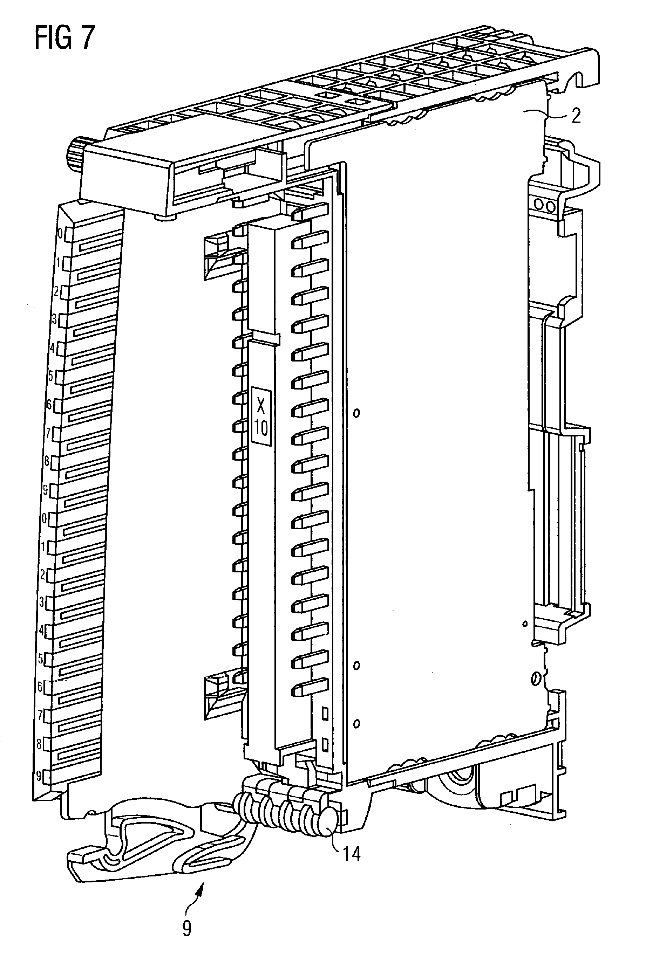

In Fig. 7 ist die elektronische Baugruppe 2 dargestellt, die in der Nähe des Gehäuseunterbodenbereichs 9 ein Codierelement 14 aufweist, das im Auslieferzustand komplett an der elektronischen Baugruppe 2 fixiert ist. Beim Einschwenken in die Kontaktierungsstellung wird das Codierelement 14 von der Steckervorrichtung 1 aufgenommen. Beim Ausschwenken wird das Codierelement 14 gebrochen. Eine Hälfte verbleibt auf der Baugruppe 2, die andere Hälfte nimmt die Steckervorrichtung 1 als Codierung mit.

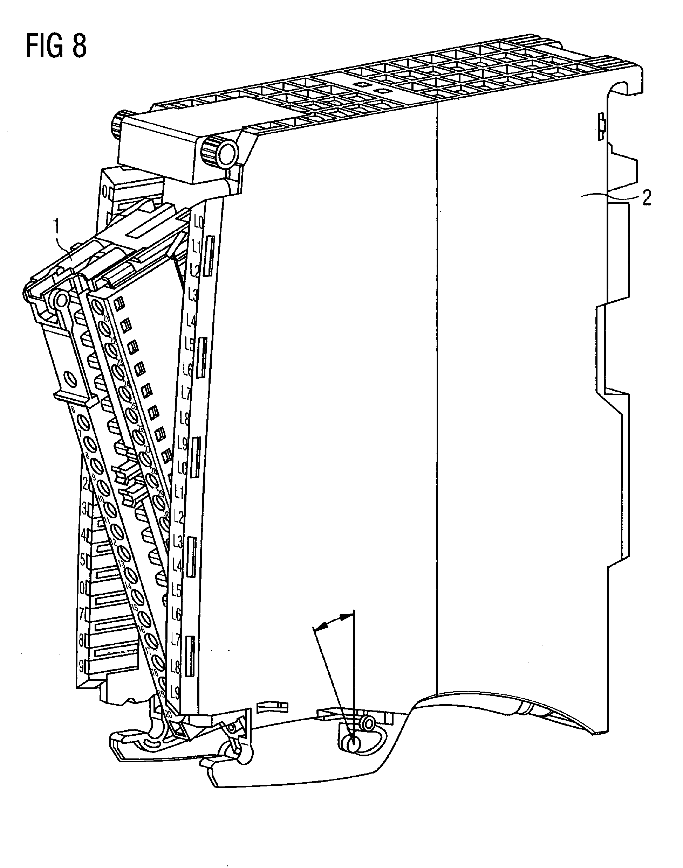

In Fig. 8 ist die erfindungsgemäße Steckervorrichtung 1 beim Ein- bzw. Ausschwenken aus der elektronischen Baugruppe 2 dargestellt. Das Codierelement 14 im Bereich des Steckerlagers bringt im Auslieferungszustand die Baugruppe 2 mit. Die Steckervorrichtung 1 kann in einem Winkel von vorzugsweise 45 bis 135° der Baugruppe zugeführt werden. Das Codierelement 14 findet immer die Aufnahme in der Steckervorrichtung 1.

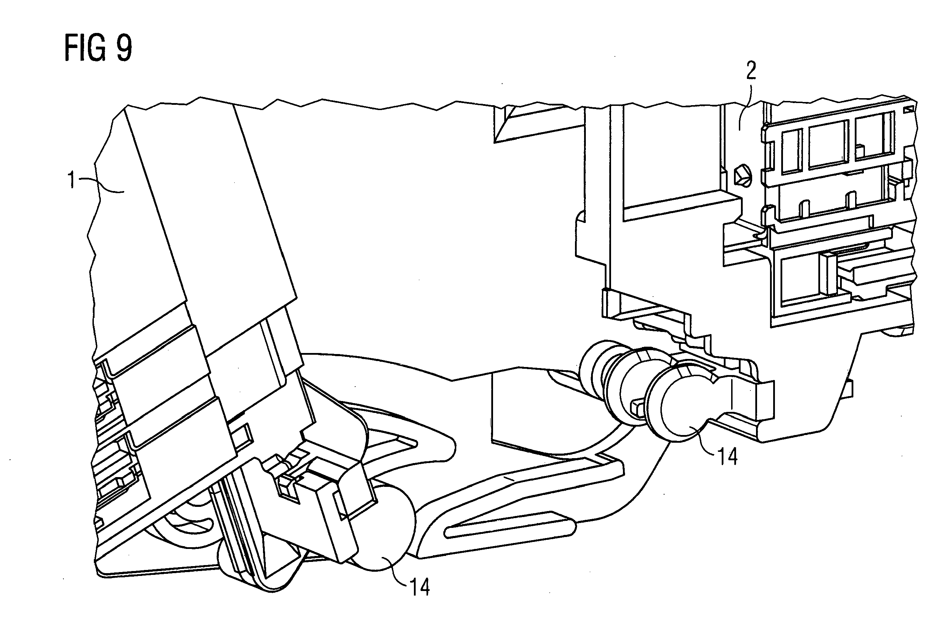

Fig. 9 zeigt die erfindungsgemäße Steckervorrichtung 1 beim Ausschwenken aus der elektronischen Baugruppe 2, wobei das Codierelement 14 in zwei Teile getrennt wird. Ein Teil der Codierung befindet sich nun an der Steckervorrichtung 1, während das andere Teil des Codierelements 14 an der elektronischen Baugruppe 2 zurückbleibt. Diese Codierung führt dazu, dass beim nächsten Zusammenführen dieser Bauelemente die erfindungsgemäße Steckervorrichtung 1 nur noch auf diesem Baugruppentyp 2 passt.

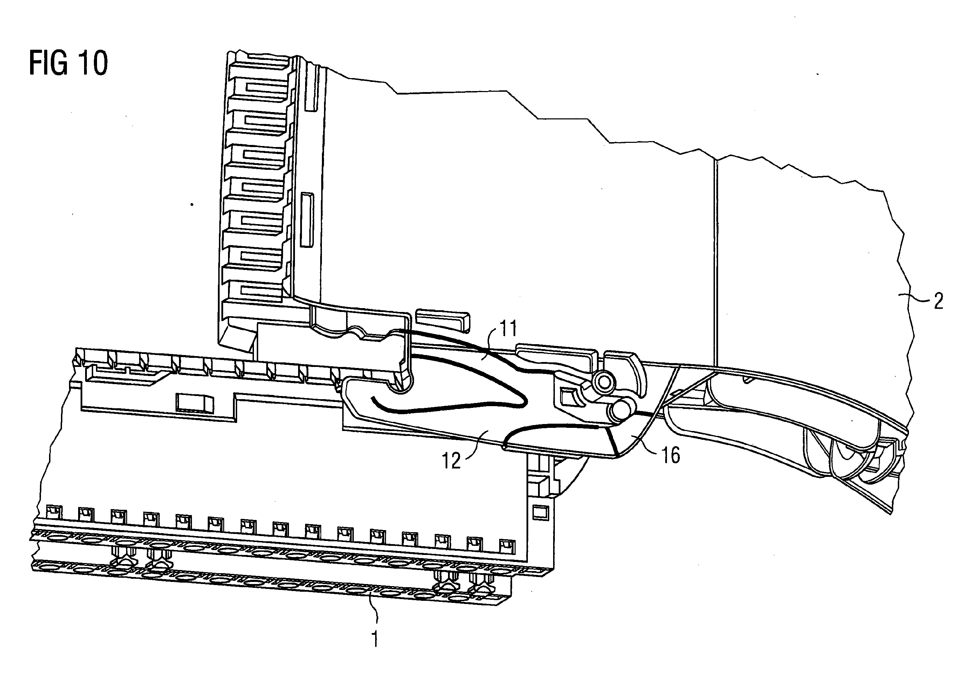

In Fig. 10 sind die Entnahmemöglichkeiten der Steckervorrichtung 1 aus der elektronischen Baugruppe 2 nach dem Ausschwenken dargestellt. Durch Zug an der Verriegelungslasche wird der Verrastungsmechanismus gelöst und die Steckervorrichtung 1 wird in der gleichen Richtung wie der Verriegelungsmechanismus betätigt und von der Baugruppe gezogen bzw. ausgeschwenkt. Eine Unterbrechung an den Zuführungsnuten der Baugruppe ermöglicht, dass die Steckervorrichtung 1 vom ausgeschwenkten Zustand aus direkt von der Baugruppe 2 entnommen werden kann. Die Steckervorrichtung 1 muss also nicht die umgekehrte Reihenfolge der Montage einhalten. In Fig. 10 sind die Führungskulissen 11, 12 sowie die direkte Entnahmemöglichkeit 16 dargestellt.

Die erfindungsgemäße Steckervorrichtung ermöglicht in ihrer Vorverdrahtungsstellung eine leicht zugängliche Vorverdrahtung außerhalb der elektronischen Baugruppe. Die zusätzliche Verwendung eines Codierelements trägt dazu bei, dass Steckervorrichtungen desselben Baugruppentyps verwendet werden können. Die erfindungsgemäße Steckervorrichtung ermöglicht sowohl einen vorverdrahteten Stecker ohne die Vorverdrahtungsstellung zu durchlaufen, in die Kontaktierungsstellung zu überführen, als auch einen nicht vorverdrahteten Stecker mittels der Vorverdrahtungsstellung in die Kontaktierungsposition zu überführen. Zudem ist die erfindungsgemäße Steckervorrichtung in einem breiten Neigungswinkelbereich von ca. 45° bis 135° anwendbar. Vorteilhaft ist ebenso, dass eine Unterbrechung in den Zuführungsnuten der elektronischen Baugruppe eine direkte Entnahme von der elektronischen Baugruppe ermöglicht, so dass die Montage nicht in umgekehrter Reihenfolge durchlaufen werden muss.

## Patentansprüche

1. Steckervorrichtung (1) für elektronische Baugruppen (2) mit einem Gehäuse (5), insbesondere in Automatisierungssystemen, aufweisend ein Anschlussfeld (3) mit Steckplätzen (4)
für eine Verdrahtung und ein Kontaktsystem, wobei das Anschlussfeld (3) der elektronischen Baugruppe (2) mittels Schwenktechnik zuführbar ist,
**dadurch gekennzeichnet, dass**
die mittels Schwenktechnik an der Baugruppe (2) verbaubare Steckervorrichtung (1) mindestens eine Vorverdrahtungsstellung außerhalb des Gehäuses (5) aufweist, wobei das Kontaktsystem aus Buchse und Messern noch nicht im Eingriff ist.

2. Steckervorrichtung (1) nach Anspruch 1,
**dadurch gekennzeichnet, dass**
die Steckervorrichtung (1) in der Vorverdrahtungsstellung mit der elektronischen Baugruppe (2) verrastbar ist.

3. Steckervorrichtung (1) nach Anspruch 1 oder 2,
**dadurch gekennzeichnet, dass**
die Steckervorrichtung (1) der Baugruppe (2) mit unterschiedlichem Neigungswinkel zuführbar ist, wobei insbesondere eine Steckerneigung zur Baugruppe (2) von ca. 45° bis 135° vorgesehen ist.

4. Steckervorrichtung (1) nach einem der vorhergehenden Ansprüche, **dadurch gekennzeichnet, dass**
die Steckervorrichtung (1) eine Vorverdrahtungslagerstelle (10) aufweist.

5. Steckervorrichtung (1) nach Anspruch 4,
**dadurch gekennzeichnet, dass**
die Steckervorrichtung (1) über einen Verriegelungsmechanismus aus der Vorverdrahtungsstellung entriegelbar ist.

6. Steckervorrichtung (1) nach einem der vorhergehenden Ansprüche, **dadurch gekennzeichnet, dass**
die Steckervorrichtung (1) mittels Führungskulissen (11, 12) im Gehäuse (5) der elektronischen Baugruppe (2) über einen Lagerzapfen einer Kontaktierungslagerstelle (13) zuführbar ist.

7. Steckervorrichtung (1) nach einem der vorhergehenden Ansprüche, **dadurch gekennzeichnet, dass**
die Baugruppe (2) im Auslieferzustand ein Codierelement (14) aufweist.

8. Steckervorrichtung (1) nach Anspruch 7,
**dadurch gekennzeichnet, dass**
beim ersten Einschwenken der Steckervorrichtung (1) auf die Baugruppe (2) ein Teil des Codierelements (14) auf die Steckervorrichtung (1) übertragbar ist, so dass die Steckervorrichtung (1) nur noch auf die so codierte Baugruppe (2) zuführbar ist.

9. Steckervorrichtung (1) nach einem der vorhergehenden Ansprüche, **dadurch gekennzeichnet, dass**
die Steckervorrichtung (1) durch Ausschwenken nach unten, wobei die Steckervorrichtung (1) in einem Winkel von ca. 90° zur elektronischen Baugruppe (2) angeordnet ist, direkt von der elektronischen Baugruppe (2) entnehmbar ist.

## Claims

1. Connector device (1) for electronic modules (2) with a housing (5), especially in automation systems, comprising a termination panel (3) with plug-in locations (4) for a wiring and a contact system, wherein the termination panel (3) is able to be guided onto the electronic module (2) by means of pivot technology,
**characterised in that**
the connector device (1) able to be assembled on the modules (2) by means of pivot technology has at least one pre-wiring position outside the housing (5), wherein the contact system of female and male connectors is not yet engaged.

2. Connector device (1) according to claim 1,
**characterised in that**
the connector device (1) is able to be latched with the electronic module (2) in the pre-wiring position.

3. Connector device (1) according to claim 1 or 2,
**characterised in that**
the connector device (1) is able to be guided onto the module (2) with different angles of inclination, wherein there is provision for the connector to be angled towards the module (2) at an angle of around 45° to 135°.

4. Connector device (1) according to one of the preceding claims, **characterised in that**
the connector device (1) has a pre-wiring support point (10)

5. Connector device (1) according to claim 4,
**characterised in that**
the connector device (1) is able to be unlocked from the pre-wiring position via a locking mechanism.

6. Connector device (1) according to one of the preceding claims, **characterised in that**
the connector device (1) is able to be guided via a support pin onto a contacting support point (13) by means of guide links (11, 12) in the housing (5) of the electronic module (2)

7. Connector device (1) according to one of the preceding claims, **characterised in that**
the module (2) comprises an encoding element (14) in its asdelivered state.

8. Connector device (1) according to claim 7,
**characterised in that**,
when the connector device (1) is first pivoted onto the module (2) a part of the encoding element (14) is able to be transferred onto the connector device (1), so that the connector device (1) is then only able to be guided onto the module (2) encoded in this way.

9. Connector device (1) according to one of the preceding claims, **characterised in that**
the connector device (1) is able to be removed directly from the electronic module (2) by pivoting it out downwards, wherein the connector device (1) is arranged at an angle of around 90° to the electronic module (2).

## Revendications

1. Dispositif de connecteur (1) pour modules électroniques (2) dotés d'un boîtier (5), en particulier dans des systèmes d'automatisation, comprenant un panneau de connexion (3) avec des emplacements (4) pour un câblage et un système de contact, le panneau de connexion (3) pouvant être amené au module électronique (2) au moyen d'une technique de pivotement,
**caractérisé en ce que**
le dispositif de connecteur (1) pouvant être installé sur le module (2) au moyen d'une technique de pivotement comprend au moins une position de précâblage à l'extérieur du boîtier (5), dans laquelle le système de contact composé d'une douille et de lames n'est pas encore engagé.

2. Dispositif de connecteur (1) selon la revendication 1,
**caractérisé en ce que**
dans la position de précâblage, un encliquetage du dispositif de connecteur (1) avec le module électronique (2) est possible.

3. Dispositif de connecteur (1) selon la revendication 1 ou 2,
**caractérisé en ce que**
le dispositif de connecteur (1) du module (2) peut être amené selon des angles d'inclinaison différents, sachant qu'il est prévu, en particulier, une inclinaison du connecteur par rapport au module (2) de 45° à 135° environ.

4. Dispositif de connecteur (1) selon l'une des revendications précédentes,
**caractérisé en ce que**
le dispositif de connecteur (1) comprend un support (10) de précâblage.

5. Dispositif de connecteur (1) selon la revendication 4,
**caractérisé en ce que**
le dispositif de connecteur (1) peut être désengagé de position de précâblage au moyen d'un mécanisme de verrouillage.

6. Dispositif de connecteur (1) selon l'une des revendications précédentes,
**caractérisé en ce que**
le dispositif de connecteur (1) peut être amené au module électronique (2) au moyen de coulisses de guidage (11, 12) prévues dans le boîtier (5), par l'intermédiaire d'un tourillon d'un support (13) de mise en contact.

7. Dispositif de connecteur (1) selon l'une des revendications précédentes,
**caractérisé en ce que**
le module (2) est livré avec un élément de codage (14).

8. Dispositif de connecteur (1) selon la revendication 7,
**caractérisé en ce que**
lors du premier pivotement du dispositif de connecteur (1) sur le module (2), une partie de l'élément de codage (14) est transférable sur le dispositif de connecteur (1), de telle sorte que le dispositif de connecteur (1) ne peut plus être amené qu'au module (2) ainsi codé.

9. Dispositif de connecteur (1) selon l'une des revendications précédentes,
**caractérisé en ce que**
le dispositif de connecteur (1), dispositif de connecteur (1) disposé selon un angle d'environ 90° par rapport au module électronique (2), peut être retiré directement du module électronique (2) par pivotement vers le bas.
